# EUROPEAN PATENT APPLICATION

(11) **EP 4 632 011 A1**
(43) Date of publication of application: **15.10.2025**
(21) Application number: 22967795.0
(22) Date of filing: 06.12.2022
(51) Int. Cl.: C08L 83/07, C08K 3/011, C08L 83/05, H01L 23/29, H01L 23/31

(54) **ORGANOPOLYSILOXANE COMPOSITION, CURED PRODUCT THEREOF, ELECTRONIC COMPONENT SEALING AGENT, ELECTRONIC COMPONENT, AND METHOD FOR PROTECTING SEMICONDUCTOR CHIP**

(71) Applicant: Dow Toray Co., Ltd., Tokyo 140-8617 (JP)
(72) Inventor: YAMAZAKI, Ryosuke, Ichihara-shi, Chiba 299-0108 (JP)
(74) Representative: Murgitroyd & Company
(86) International application number: PCT/JP2022/044937
(87) International publication number: WO 2024/121942

(57) **Abstract**

The present invention relates to a hydrosilylation-curable organopolysiloxane composition which contains an organopolysiloxane and an organohydrogenpolysiloxane crosslinked via a hydrosilylation reaction, a nonreactive organopolysiloxane resin which exhibits a mass loss rate of 2.0 mass% or less when exposed to 200°C for 1 hour, and optionally a reaction product of an alkali metal silanolate and at least one or more cerium chlorides and/or carboxylates. The composition has a low elastic modulus and low stress, and has excellent strength, cold resistance, and transparency. Furthermore, the addition of a cerium compound allows these characteristics to be maintained even under high temperature conditions for a long period of time, and provides a cured product that is resistant to cracking, peeling, and the like, particularly when a strong temperature gradient occurs inside the composition.

## Description

### TECHNICAL FIELD

The present invention relates to an organopolysiloxane composition that provides a cured product with excellent transparency and strength, and further relates to an organopolysiloxane composition that provides an organopolysiloxane cured product that has excellent heat resistance, particularly crack resistance, even when a temperature difference occurs inside a member at high temperatures, due to the addition of specific additives. Furthermore, the present invention relates to an electronic component sealant containing the organopolysiloxane composition, and an electronic component provided with the organopolysiloxane cured product.

### BACKGROUND ART

The curable organopolysiloxane composition contains, as a main component, an organopolysiloxane in which siloxane units are polymerized, and that forms an organopolysiloxane cured product by reaction with a crosslinking agent or the like. Of curable organopolysiloxane compositions, those compositions that cure via a hydrosilylation reaction generally contain an organopolysiloxane having an alkenyl group, such as a vinyl group, bonded to a silicon atom, an organohydrogenpolysiloxane having a hydrogen atom bonded to a silicon atom (also referred to as a SiH group), and a hydrosilylation catalyst, and are cured via an addition reaction between the SiH group and the alkenyl group (for example, Patent Documents 1 to 4). The crosslink density of the cured product of the curable organopolysiloxane composition can be designed by adjusting the ratio of SiH groups to alkenyl groups, and desired physical and chemical properties can be imparted to the cured product. In particular, many of the low crosslink density organopolysiloxane cured products known as "silicone gels" have excellent heat resistance, weather resistance, oil resistance, cold resistance, electrical insulation, and the like, and also have a low elastic modulus and low stress. By taking advantage of the low elastic modulus and low stress properties not found in other materials such as various elastomers and the like, cured organopolysiloxane gels are used as sealants for protecting electronic components such as in-vehicle electronic components, consumer electronic components, display components, and the like, or for bonding components together. In recent years, in response to demand for higher reliability for these members, there is a need for organopolysiloxane materials containing gel-like organopolysiloxane cured products to have even greater strength. In particular, displays used as in-vehicle components and small cameras for outdoor sports are exposed to strong or continuous vibrations, so strength is required in the bonded members.

Furthermore, depending on the application, organopolysiloxane cured products are required to have greater cold and heat resistance than ever before, and there is a demand for improved reliability, including physical strength, over a wide temperature range. As an example, in recent years, the widespread use of power devices has required that the operating temperature of electronic components be increased from the conventional 150°C to 175°C, for electronic components that operate under high voltages and large currents to control and convert power, particularly silicon chips. Furthermore, the spread of SiC semiconductors often requires operating temperatures to be 200°C or higher. Therefore, methods have been proposed for improving the heat resistance of the gel-like organopolysiloxane cured products used as protective materials for these devices by adding various heat-resistant additives (for example, Patent Documents 4 to 7). Some organopolysiloxane cured products obtained by curing organopolysiloxane compositions containing these heat-resistant additives exhibit sufficient heat resistance to retain a low elastic modulus, even when exposed to temperatures exceeding 200°C for a long period of time.

However, simply providing the organopolysiloxane cured product with high heat resistance is not sufficient to ensure the reliability of power devices. Power semiconductor modules used in power devices generate heat during operation, but the heat source is the bottom surface of the module, so depending on the shape or structure of the device, of the organopolysiloxane cured material used as a protective material, only the bottom surface of the module is exposed to high heat, resulting in a large temperature difference within a single member. A temperature gradient caused by temperature differences in this member generates internal stress due to a difference in the expansion rate inside the organopolysiloxane cured product, and in particular, cracks (fissures and cracks) appear in the organopolysiloxane cured product with the passage of time/thermal cycling, thus degrading the protective function thereof. The organopolysiloxane compositions described in Patent Document 4 and the like provide organopolysiloxane cured products with excellent elastic properties even at higher temperatures exceeding 200°C. However, there is still room for improvement in terms of the technical issue of preventing cracking caused by temperature differences within a member.

### RELATED ART DOCUMENTS

### Patent Documents

Patent Document 1: Japanese Unexamined Patent Application Publication S48-017847
Patent Document 2: Japanese Unexamined Patent Application S56-143241
Patent Document 3: International Patent Application Publication WO 2015-034029
Patent Document 4: Japanese Unexamined Patent Application H08-225743
Patent Document 5: International Patent Application Publication WO 2015-111409
Patent Document 6: Japanese Unexamined Patent Application 2018-053015
Patent Document 7: Japanese Unexamined Patent Application 2021-011510

### SUMMARY OF THE INVENTION

### PROBLEM TO BE SOLVED BY THE INVENTION

In light of the foregoing, an object of the present invention is to solve the problems with storage, preservation, and reliability of electronic component sealants containing an organopolysiloxane composition, and bonding members for electronic components containing a cured product of the organopolysiloxane composition. Another object of the present invention is to improve the performance of the organopolysiloxane cured product obtained by curing the organopolysiloxane composition, or in other words, to improve the problems of: insufficient strength of conventional organopolysiloxane cured products, long-term use at high temperatures causing deterioration in elastic modulus, stress, and transparency; and cracks likely occurring inside the organopolysiloxane cured product when a large temperature difference occurs inside a member. Another object of the present invention is to improve the loss of reliability and continuous service life of electronic components caused by insufficient strength and heat resistance of the organopolysiloxane cured products used in electronic components, and deterioration thereof.

### MEANS FOR SOLVING THE PROBLEM

As a result of intensive research, the present inventors found that the aforementioned problems can be effectively solved by preparing a hydrosilylation reaction-curable organopolysiloxane composition that does not contain low molecular weight siloxane oligomers but contains an organopolysiloxane resin that has at least a certain amount of branched siloxane units but does not contain an alkenyl group, and then using a cured product thereof. In other words, the present inventors discovered that the aforementioned problems related to strength and adhesive strength can be solved by using a curable organopolysiloxane composition containing: (A) an organopolysiloxane having, on average, at least two alkenyl groups bonded to silicon atoms per molecule and having a viscosity at 25°C in a range of 10 to 10000 mPa·s; (B) an organopolysiloxane resin expressed by the following general formula:

(R¹₃SiO_{1/2})ₐ(SiO_{4/2})_{b}(R²O_{1/2})_{c}

(where each R¹ is independently a monovalent hydrocarbon group having 1 to 10 carbon atoms and not containing a carbon-carbon double bond; R² is a hydrogen atom or an alkyl group having 1 to 10 carbon atoms; and a, b, and c are numbers satisfying 0.35≦a≦0.55, 0.45≦b≦0.65, 0≦c≦0.05, and a + b = 1),
the mass loss rate when exposed to 200°C for 1 hour being 2.0 mass% or less; (C) an organohydrogenpolysiloxane having at least two hydrogen atoms bonded to silicon atoms in each molecule and having a viscosity at 25°C in a range of 2 to 10000 mPa·s; and (D) a hydrosilylation catalyst; and furthermore, the problems related to heat resistance and crack generation can be resolved by the addition of (E) reaction products of (e1) an alkali metal silanolate compound and (e2) cerium chloride or cerium carboxylate. Thereby the present invention was achieved. Furthermore, the present inventors also found that the above problems can be solved by an electronic component sealant or laminating agent containing the organopolysiloxane composition, an organopolysiloxane cured product obtained by curing the organopolysiloxane composition, a laminating member containing the same, and an electronic component provided with the same, thereby completing the present invention.

More specifically, the organopolysiloxane composition of the present invention contains 10 to 80 parts by mass of component (B) per 100 parts by mass of component (A), component (C) in an amount such that there are 0.5 to 2.0 hydrogen atoms bonded to silicon atoms per alkenyl group bonded to silicon atoms in the entire composition, and component (D) in a catalytic amount sufficient to cause component (A) to react with and cure component (C). Furthermore, if heat resistance is required, the composition contains 0 to 10.0 parts by mass of component (E). Component (E) may contain 0.5 to 5.0 mass% of cerium atoms, and when added, the amount may be such that the amount of cerium atoms or the like in component (E) is 0.005 to 0.15 mass%, relative to the entire organopolysiloxane composition.

Furthermore, components (A) and (C) may be branched, linear, or a mixture thereof.

Furthermore, the present invention provides an electronic component sealant, particularly a sealant for power devices, which contains the organopolysiloxane composition. The sealant may be substantially transparent. Furthermore, the present invention also provides a bonding member for electronic components, which contains the organopolysiloxane composition.

The organopolysiloxane composition of the present invention is curable, and a cured product can be obtained by a hydrosilylation reaction. The present invention provides this organopolysiloxane cured product. The organopolysiloxane cured product of the present invention is substantially transparent, and immediately after completion of the curing reaction, the direct reading of 1/4 consistency as specified in JIS K2220 is within a range of 10 to 150. The cured product having improved heat resistance containing component (E) of the present invention maintains at least 50% of the direct reading of 1/4 consistency immediately after completion of the curing reaction, even after being held at 225°C for 1000 hours. The organopolysiloxane cured product can be used to protect electronic components and to maintain adhesion. The organopolysiloxane cured product of the present invention may be substantially transparent.

The organopolysiloxane composition of the present invention and the sealing material or laminating member thereof can be placed in contact with or around an electronic component such as a semiconductor, cured by heating, and then the cured product can be placed in the proper position. Therefore, the present invention provides an electronic component containing the organopolysiloxane cured product. Furthermore, if the electronic component is an optical component or optoelectronic component such as a light emitting diode or the like, the present invention provides a general lighting fixture, optical member, or optoelectronic member, containing the aforementioned organopolysiloxane cured product. In particular, the present invention provides a semiconductor chip used in harsh environments, which includes the organopolysiloxane cured product containing component (E), and a device including the same. The semiconductor chips include light emitting semiconductor elements such as LEDs and the like, and power semiconductors, and the present invention provides a power device that is particularly resistant to heat and cold.

Furthermore, the present invention provides a method for protecting semiconductor chips using the organopolysiloxane composition of the present invention and a cured product thereof. The present invention is also provided for applications where heat and cold resistance are particularly required.

### EFFECT OF THE INVENTION

The organopolysiloxane composition of the present invention provides a cured product that has excellent intrinsic gel strength and excellent mass-producibility by exhibiting reduced lot-to-lot variation in gel hardness as measured by the degree of needle penetration, which is generally considered difficult to achieve. Furthermore, adding a component containing cerium to the composition can provide an organopolysiloxane cured product after curing with excellent heat resistance and transparency even at a high temperature exceeding 200°C, that can maintain a low elastic modulus, low stress, and high transparency even when used for a long period of time at high temperature, and that is less likely to crack even when a large temperature difference occurs inside a member over a long period of time, such as when a high-temperature heat source is installed only on the bottom surface of the cured product. Furthermore, the present invention can provide an electronic component sealant containing this composition, and an electronic component containing the aforementioned organopolysiloxane cured product.

The organopolysiloxane cured product of the present invention has superior strength to conventional organopolysiloxane cured products, so when used as a sealant or laminating member for electronic components such as in-vehicle electronic components, consumer electronic components, display members, and the like, these components can be protected for a longer period of time and the reliability can be enhanced. Furthermore, if the organopolysiloxane cured product of the present invention with heat resistance is used for protecting electronic components such as an IC, hybrid IC, and the like, transparency can be maintained even at a high temperature of 200°C or more, as is required for SiC semiconductors, and furthermore, strength, heat resistance, and cold resistance will be excellent, so improved long-term durability can be expected. Furthermore, even under conditions of use in which large temperature differences occur inside the organopolysiloxane cured product due to providing a heat source, or under extreme environments such as outer space where the material is exposed to extreme or partial temperature changes, problems such as cracking are unlikely to occur and degradation over time is impeded, so electronic components that are highly reliable and durable even under these conditions of use can be provided.

### DESCRIPTION OF THE PREFERRED EMBODIMENTS

Each of components will be described below in detail. Note that in the present specification, the siloxane unit may be expressed as an M unit (A₃SiO_{1/2}), a D unit (A₂SiO_{2/2}), a T unit (ASiO_{3/2}), or a Q unit (SiO_{4/2}) depending on the number of siloxane oxygen atoms bonded to silicon atoms, where A is an atom or group other than -OSi. Furthermore, the viscosity is a value measured at 25°C using a B-type viscometer in accordance with JIS K7117-1.

Curable organopolysiloxane composition
(A) Organopolysiloxane having an alkenyl group Component (A) is an organopolysiloxane having alkenyl groups, and is one of the main components (base polymer) of the organopolysiloxane composition of the present invention. The organopolysiloxane contains, on average, at least two alkenyl groups bonded to silicon atoms (hereinafter also referred to as "silicon-bonded alkenyl groups") per molecule, and has a viscosity at 25°C within a range of 10 to 10000 mPa·s. More specifically, component (A) may be one or a mixture of the following component (A-1) and component (A-2), and may also optionally contain an alkenyl group-containing organopolysiloxane resin as component (A-3). Component (A-1) is capable of imparting cold resistance to the organopolysiloxane cured product, and component (A-2) is capable of improving the strength of the organopolysiloxane cured product. Depending on the properties to be expressed, component (A-1) and component (A-2) may be combined. Furthermore, the cold resistance can be enhanced by combining with component (B) described below, and these combinations are also described below.

Component (A-1) is a branched organopolysiloxane that contains, on average, at least two silicon-bonded alkenyl groups per molecule. Component (A-1) may have a structure branched by a certain number of RSiO_{3/2} (where R is a monovalent hydrocarbon group) units. Component (A-1) can be preferably expressed by the following average structural formula (1):

(R₃SiO_{1/2})_{d}(R₂SiO_{2/2})ₑ(RSiO_{3/2})_{f} (1)

In formula 1, R represents a monovalent hydrocarbon group, d, e and f are each positive numbers, and the percentages of d, e and f relative to the total amount satisfy 0.1≦d≦10.0, 80.0≦e≦99.8 and 0.1≦f≦10.0.

The branched organopolysiloxane of component (A-1) has a specific number of branched structures. Specifically, of all the siloxane units constituting component (A-1), the amount of R₃SiO_{1/2} units is 0.1 mol% or more, 1.0 mol% or more, or 3.0 mol% or more, and simultaneously 10.0 mol% or less; the amount of R₂SiO_{2/2} units is 80.0 mol% or more and simultaneously 99.8 mol% or less, 98.9 mol% or less, or 96.9 mol% or less; and the RSiO_{3/2} units are 0.1 mol% or more, 1.0 mol% or more, or 3.0 mol% or more and simultaneously 10.0 mol% or less. In other words, the ratio of d:e:f in formula 1 corresponds to the ratio of mol%. Component (A-1) has a branched structure, so an organopolysiloxane cured product that has excellent cold resistance can be obtained, particularly at low temperatures. Note that the molar ratio of the R₂SiO_{2/2} units, RSiO_{3/2} units, and R₃SiO_{1/2} units is a value determined by measurements using nuclear magnetic resonance (NMR).

In component (A-1), the monovalent hydrocarbon group bonded to a silicon atom in the siloxane structural unit (or in other words, R as defined above) is located in a side chain of the main chain or a branched chain, or at a terminus, and is i) a monovalent hydrocarbon group which does not contain an aliphatic unsaturated bond and which may or may not have a substituent, or ii) a monovalent alkenyl group. Component (A-1) has, on average, at least two alkenyl groups bonded to silicon atoms in the molecule.

When R is i) a monovalent hydrocarbon group which does not contain an aliphatic unsaturated bond and which may or may not have a substituent, the number of carbon atoms therein may be 1 or more and simultaneously any integer within a range of 2 or less, 3 or less, 4 or less, 6 or less, 8 or less, 9 or less, or 10 or less. The number of carbon atoms in R is preferably in a range of 1 to 6. Specific examples of the monovalent hydrocarbon group which does not contain an aliphatic unsaturated bond and which may or may not have a substituent includes alkyl groups; aryl groups; and aralkyl groups; among these, methyl groups, ethyl groups, phenyl groups, and benzyl groups are preferable, and in particular, methyl groups and phenyl groups are preferable due to the ease of synthesis. Alternatively, some or all of the hydrogen atoms of these groups may be substituted with a halogen atom like chlorine, bromine or fluorine, such as a chloromethyl group or a 3,3,3-trifluoropropyl group.

When R is ii) a monovalent alkenyl group, the number of carbon atoms in the alkenyl group is at least 2 carbon atoms, or is any integer in a range of 3 or less, 4 or less, or 6 or less, or is an alkenyl group having 2 to 4 carbon atoms, or 2 to 3 carbon atoms. Specific examples thereof include vinyl, allyl, isopropenyl, butenyl, and isobutenyl groups, with vinyl being particularly preferred.

In the above average structural formula (1) of component (A-1), the proportion of silicon-bonded alkenyl groups, expressed as mol%, of all monovalent hydrocarbon groups R bonded to silicon atoms is 0.10 or more, 0.25 or more, or 0.50 or more, and may be 4.00 mol% or less, or 2.00 mol% or less. Note that the amount of alkenyl groups mentioned above is a value determined by a Fourier transform near infrared spectrometer.

The viscosity of component (A-1) at 25°C is within a range of 10 to 10000 mPa·s, or may be within a range of 10 to 5000 mPa·s, or 10 to 1000 mPa·s at 25°C.

The branched organopolysiloxane which is component (A-1) can be synthesized with a desired viscosity and design structure by a conventionally known method. For example, preparation is possible by heating and equilibrium polymerization of a hydrolysate having siloxane units of RSiO_{3/2}, R₂SiO_{2/2}, and R₃SiO_{1/2} with ViR^{O}₂SiOSiR^{O}₂Vi and cyclic polysiloxane (R^{O}₂SiO)_{y} (In each formula, R represents a monovalent hydrocarbon group that does not contain an aliphatic unsaturated bond such as an alkyl group or the like, and Vi represents an alkenyl group such as a vinyl group or the like) in the presence of potassium silanolate in accordance with the Embodiments and the like in Japanese Unexamined Patent Application S61-16295.

A so-called gel-like organopolysiloxane cured product that has flexibility can be obtained by including silicon-bonded alkenyl groups in the aforementioned amount in component (A-1), such that after completion of curing, the direct reading of 1/4 consistency as specified in JIS K 2220 is in a range of 10 to 150. In the present invention, the term "completion of curing" refers to the timing after the curable organopolysiloxane composition has been allowed to stand at 80°C for one hour.

By having the aforementioned viscosity, component (A-1) contributes to improving the handling ease and flowability of the organopolysiloxane composition of the present invention, as well as the strength of the resulting cured product. Here, the strength of the cured product refers to the degree to which the cured product can withstand stress without breaking. In other words, higher strength of the cured product indicates greater stress required to break the cured product. In the present invention, strength is measured by the same method as the measurement of adhesive strength. In other words, if cohesive failure occurs rather than peeling during adhesive strength testing, the cured product itself breaks and the measurement ends, and the strength of the subject organopolysiloxane cured product is expressed as a numerical value of the stress at which cohesive failure occurs during the adhesive strength test.

By using component (A-1), the organopolysiloxane composition of the present invention can provide an organopolysiloxane cured product that has excellent cold resistance, even at low temperatures below -40°C, in addition to the strength described above.

Component (A-2) is a linear organopolysiloxane that contains, on average, at least two silicon-bonded alkenyl groups per molecule. Component (A-2) can be preferably expressed by the following average structural formula (2):

R₃SiO(R₂SiO)ₕSiR₃ (2)

(In formula (2), R represents a monovalent hydrocarbon group similar to R in general formula (1) of component (A-1) described above, and is i) a monovalent hydrocarbon group which does not contain an aliphatic unsaturated bond and which may or may not have a substituent, or ii) a monovalent alkenyl group. h represents a positive number, and is a number within a range of 100 or more, 150 or more, or 200 or more, and at the same time 300 or less, 400 or less, or 500 or less.)

Of all the siloxane units constituting component (A-2), R₃SiO_{1/2} units account for, in terms of mol%, 0.1 or more, 0.5 or more, or 1.0 or more and at the same time 10.0 or less, 5.0 or less, or 3.0 or less, with R₂SiO_{2/2} units constituting the remainder, or in other words, in terms of mol%, 90.0 or more, 95.0 or more, or 97.0 or more and at the same time 99.9 or less, 99.5 or less, or 99.0 or less. Here, the ratio of g:h in formula 2 corresponds to the ratio of mol%. Note that the molar ratio of R₂SiO_{2/2} units to R₃SiO_{1/2} units can be determined by measurement using nuclear magnetic resonance (NMR).

In the above average structural formula (2) of component (A-2), the proportion of silicon-bonded alkenyl groups, expressed as mol%, of all monovalent hydrocarbon groups R bonded to silicon atoms is 0.25 or more, 0.50 or more, or 1.00 or more, and at the same time may be 4.00 or less, 3.00 or less, or 2.00 or less. Note that the amount of alkenyl groups can be determined using a Fourier transform near infrared spectrometer.

The viscosity of component (A-2) at 25°C is in a range of 10 to 10000 mPa·s, but may be in a range of 1.0 or more, or 5.0 or more, and at the same time, 5000 or less, or 1000 or less, at 25°C.

Component (A-2) may be a so-called gel-like organopolysiloxane cured product with flexibility that can be obtained by including the aforementioned structure, such that after completion of curing, the direct reading of 1/4 consistency as specified in JIS K 2220 is in a range of 10 to 150. By having the aforementioned viscosity, component (A-2) contributes to improving the handling ease and flowability of the organopolysiloxane composition of the present invention, as well as the strength of the resulting cured product.

Examples of the linear organopolysiloxane expressed by the average structural formula (2) include polymers made of dimethylsiloxane, and furthermore, examples include polymers made of methyltrifluoropropylsiloxane; copolymers containing methylvinylsiloxane and/or diphenylsiloxane-phenylmethylsiloxane in any ratio in addition to dimethylsiloxane and/or methyltrifluoropropylsiloxane, and also polymers in which both ends of the polymer are blocked with dimethylvinylsiloxy groups, methyldivinylsiloxy groups, or trivinylsiloxy groups, or one end is blocked with a trimethylsiloxy group and the other end is blocked with a dimethylvinylsiloxy group; copolymers containing vinylmethylsiloxane, dimethylpolysiloxane, and/or methyltrifluoropropylpolysiloxane in any ratio, and optionally containing diphenylsiloxane or phenylmethylsiloxane, both ends of which are blocked with trimethylsiloxy groups; and the like.

Of the linear organopolysiloxanes exemplified above, those which do not contain phenyl groups, so-called dimethylpolysiloxanes, are effective in improving the mechanical strength of the cured product obtained by curing the organopolysiloxane composition of the present invention, but are unable to impart cold resistance as does the aforementioned component (A-1). In contrast, copolymers containing phenyl groups (so-called phenyl group-containing organopolysiloxane), such as dimethylsiloxane-diphenylsiloxane copolymers with both ends blocked by dimethylvinylsiloxy groups, contribute to cold resistance. Therefore, when cold resistance is not required, component (A-2) containing only dimethylpolysiloxane may be used as component (A) without adding component (A-1). However, in order to achieve both cold resistance and mechanical strength, component (A-2) should be used in combination with component (A-1), and/or component (A-2) should contain a phenyl group-containing polysiloxane. In this case, cold resistance can be imparted to the resulting cured product by controlling the amount of phenyl groups in the composition to the amount described below.

Regardless of whether (A-1) or (A-2) is used, when a phenyl group-containing organopolysiloxane is used as all or a portion of component (A), the amount of phenyl groups, expressed as mol% relative to all functional groups bonded to silicon atoms, should be within a range of 1 or more, or 3 or more, and at the same time, 10 or less, or 7 or less. This is because if the amount of phenyl groups exceeds 10 mol%, the phenyl groups in the cured product can increase the hardness of the organopolysiloxane cured product, resulting in a loss of flexibility, and, depending on the amount blended, a gel-like cured product with the low hardness required for stress relaxation properties may be difficult to form. Furthermore, if the amount of phenyl groups is less than the lower limit of 1 mol%, sufficient cold resistance may not be imparted to the cured product of the organopolysiloxane having a dimethylpolysiloxane skeleton.

Note that regardless of whether component (A-1) or component (A-2) is used, the mechanical strength of the organopolysiloxane cured product of the present invention can be improved by using the aforementioned so-called phenyl group-containing organopolysiloxane as a main component, and adding the aforementioned so-called dimethylpolysiloxane. Even in this case, the amount of phenyl groups of the curable organopolysiloxane composition is preferably within the range exemplified in the previous paragraph. In particular, if the phenyl group content exceeds the upper limit described above, mutual dissolving with the dimethylpolysiloxane used in combination may become difficult, and the uniformity of the overall composition may be impaired.

As for the quantitative relationship between the component (A-1) and the component (A-2), as described above, each may be used alone or in combination, and from the viewpoint of the ability to establish both cold resistance and mechanical strength of a resulting organopolysiloxane cured product, the dimethylpolysiloxane-based component (A-2) is 2 to 150 parts by mass, or 2 to 100 parts by mass with respect to 100 parts by mass of component (A-1). By using a ratio within this quantitative range, the cold resistance and physical properties of the resulting organopolysiloxane cured product can be improved, and the handling properties of the organopolysiloxane composition before curing can be further improved. Furthermore, there are also advantages in terms of cost.

The optional component (A-3) is an alkenyl group-containing organopolysiloxane resin, and is a organopolysiloxane component that is resinous, or in other words, has a three-dimensional branched structure. Component (A-3) contains at least two alkenyl groups on average in a molecule, and is an organopolysiloxane resin where at least 20 mol% of all moles of siloxane units are selected from siloxane units expressed by R^{r}SiO_{3/2} (where R^{r} represents a monovalent organic group) and siloxane units expressed by SiO_{4/2}. R^{r} is a monovalent organic group similar to R in general formula (1) of component (A-1), or in other words, i) a monovalent hydrocarbon group which does not contain an aliphatic unsaturated bond and which may or may not have a substituent, or ii) a monovalent alkenyl group, or a hydroxyl group.

The description in the present application regarding the alkenyl group contained in component (A-1) applies to the alkenyl group in component (A-3). The alkenyl groups are particularly exemplified by vinyl or hexenyl groups. The alkenyl group has hydrosilylation reactivity, and thus is incorporated into the crosslinking reaction that forms the organopolysiloxane cured product, and is expected to have the effect of improving the mechanical strength of the resulting cured product.

Examples of groups bonded to silicon atoms in component (A-3) other than alkenyl groups include hydroxyl groups, or unsubstituted or substituted monovalent hydrocarbon groups which do not contain aliphatic unsaturated bonds, and the number of carbon atoms may be any integer within a range of 1 or more and at the same time 2 or less, 3 or less, 4 or less, or 6 or less, or may be any integer within a range of 6 or more or 7 or more, and at the same time 8 or less, 9 or less, 10 or less, 12 or less, 16 or less, 18 or less, or 20 or less. Specific examples of the unsubstituted or substituted monovalent hydrocarbon group that does not contain an aliphatic unsaturated bond include alkyl groups; aryl groups; aralkyl groups; and groups in which some or all of the hydrogen atoms in these groups have been substituted with halogen atoms such as chlorine, bromine or fluorine, or alkoxy groups substituted with hydroxyl groups. Of these, methyl, ethyl, phenyl and benzyl groups are exemplified, and in particular, methyl, phenyl and 3,3,3-trifluoropropyl groups are exemplified due to ease of synthesis. From the viewpoint of mutual solubility with other components contained in the composition, an alkyl group, particularly a methyl group, is preferred.

When component (A-3) is added, the amount added is arbitrary, but can be added in a range of more than 0.0, or 0.10 or more and at the same time 10 or less, 7.5 or less, or 5.0 or less, expressed as mass% relative to the entire organopolysiloxane composition of the present invention. In addition to the component (A-1) and component (A-2) above, the mechanical strength of the resulting organopolysiloxane cured product can be improved by bringing the amount of component (A-3) within this range. The added amount of the (A-3) component can be said to have a significant effect on improving the mechanical strength when the added amount is 0.10 mass% or more. Furthermore, if the amount exceeds 10 mass%, the viscosity of the organopolysiloxane composition at 25°C may be too high, so the resulting cured product may be too hard, which is undesirable from a practical standpoint.

(B) Organopolysiloxane resin that does not contain an alkenyl group and has a low amount of low molecular weight molecular species Component (B) is one of the main components of the present invention, and is an organopolysiloxane resin containing no alkenyl groups. Specifically, component (B) is an organopolysiloxane resin referred to as an MQ resin, composed of siloxane units (M units) expressed by (R¹₃SiO_{1/2}) and siloxane units (Q units) expressed by (SiO_{4/2}). In the present invention, component (B) has a low amount of low molecular weight reaction by-products as described below, and therefore exhibits a mass loss of 2.0 mass% or less when exposed to 200°C for 1 hour. The MQ resin of the present invention has a low amount of low molecular weight reaction by-products.

The organopolysiloxane resin of component (B) can specifically be expressed by the following average structural formula (3):

(R¹₃SiO_{1/2})ₐ(SiO_{4/2)}b(R²O_{1/2})_{c} (3)

(In the formula, a, b, and c satisfy 0.35≦ a ≦0.55, 0.45 ≦ b ≦ 0.65, 0 ≦ c ≦ 0.05, and a + b = 1.)
In the above average structural formula (3), each R¹ is an independent monovalent hydrocarbon group not containing an aliphatic unsaturated bond, and the number of carbon atoms therein may be any integer in a range of 1 or more and at the same time 2 or less, 3 or less, 4 or less, 6 or less, 8 or less, 9 or less, or 10 or less. The structure is a group selected from the group consisting of alkyl groups, aryl groups, and aralkyl groups, and in particular, examples include methyl groups and phenyl groups. Here, an example of component (B) is one in which 70 mol% or more of all R¹ in one molecule are alkyl groups having 1 to 10 carbon atoms, particularly methyl groups, and furthermore, 88 mol% or more of all R¹ in each molecule are alkyl groups having 1 to 10 carbon atoms, particularly methyl groups, from the standpoint of industrial production and the technical effect of the invention.

Furthermore, in the above formula (3), R² is a hydrogen atom or an alkyl group, and in the case of an alkyl group, the number of carbon atoms may be any integer within a range of 1 or more and at the same time, 2 or less, 3 or less, 4 or less, 6 or less, 8 or less, 9 or less, or 10 or less. Examples of the alkyl group of R² include methyl, ethyl, propyl, butyl, pentyl, and hexyl groups. The group R²O_{1/2} containing R² corresponds to a hydroxyl group or an alkoxy group, and the oxygen atom thereof is bonded to the silicon atom of the siloxane unit.

In the above formula (3), a, b, and c respectively represent the proportion of M units (siloxane units expressed by R¹₃SiO_{1/2}), Q units (siloxane units expressed by SiO_{4/2}), and hydroxyl groups or alkoxy groups expressed by R²O_{1/2}.

In the above formula (3), a is a number within a range of 0.35 or more, 0.40 or more, or 0.45 or more, and at the same time 0.60 or less, or 0.55 or less. If "a" is at least as large as the lower limit of the aforementioned range, the viscosity of the composition containing this component can be prevented from becoming too high. On the other hand, if "a" is less than or equal to the upper limit of the aforementioned range, the mechanical strength (hardness, elongation rate, and the like) of the organopolysiloxane cured product obtained by curing the curable silicone composition of the present invention will not be too low.

In the above formula (3), "b" is a number within a range of 0.40 or more, or 0.45 or more, and at the same time 0.7 or less, or 0.65 or less. If "b" is within the above range, the viscosity of the composition containing this component will not be too high, and the cured product obtained by curing the composition will have excellent mechanical strength.

In the above formula (3), "c" may be 0, but in any case, is a number within a range of 0.0 or more and at the same time 0.05 or less, or 0.03 or less. When "c" is equal to or less than the upper limit of the range, compositions containing this component exhibit excellent thermosetting properties.

Component (B) is produced by an equilibrium reaction of raw materials which provide Q units constituting the resinous polymer portion and M units which become the terminus, so the molecular weight of component (B) can be controlled by the ratio of M units to Q units, or in other words, the aforementioned values of "a" and "b". Within the aforementioned ranges of "a" and "b", the molecular weight is in a range of 2,000 to 25,000 as measured by gel permeation chromatography (GPC) using toluene as a solvent (based on a polystyrene standard).

The so-called MQ resin, which is the main molecular species of component (B), can be synthesized to the desired molecular weight and design structure by known methods, but in the present invention, the MQ resin incorporated in the composition has a mass loss rate of 2.0 mass% or less when exposed to 200°C and ambient pressure for 1 hour. The mass loss under these conditions is due to the presence of low molecular weight components which volatilize under these conditions. In the process for producing component (B), volatile low molecular weight components appear as by-products during polymerization of the organopolysiloxane resin containing M units and Q units. This volatile low molecular weight component is referred to herein as the "M₄Q structure". If the M₄Q structure is incorporated into the organopolysiloxane composition of the present invention, the effect of significantly lowering the hardness of the organopolysiloxane cured product obtained by curing the organopolysiloxane composition can be achieved, and the hardness of the obtained organopolysiloxane cured product changes significantly depending on the amount of the M₄Q structure, and the change is also evident by the degree of needle penetration, which is an indicator of the hardness.

M₄Q structures are known to decrease and are eventually removed when an organopolysiloxane resin containing these structures is maintained at a temperature of 200°C or higher. Therefore, an organopolysiloxane cured product made of an organopolysiloxane resin containing the M₄Q structure as a portion of the composition is aged at a temperature of 200°C or higher, and the M₄Q structure gradually volatilizes. As volatilization progresses, the degree of needle penetration into the organopolysiloxane cured product decreases significantly, an indication that the hardness of the cured product is increasing. In other words, when an MQ resin is produced by a known method, the resin contains a certain amount or more of M₄Q structures. Therefore, if the organopolysiloxane composition is produced using an existing MQ resin that is not purified in particular, the heat resistance of the cured product obtained by curing will be inferior, and will deteriorate over time, in particular. Furthermore, the amount of M₄Q structures usually varies between each lot of MQ resin, so if this MQ resin is used in a curable organopolysiloxane composition, the degree of needle penetration into the resulting cured product will vary between lots, creating a problem with quality stability. Therefore, the curable organopolysiloxane composition of the present invention does not contain an M₄Q structure, and therefore the M₄Q structures must be removed after synthesis of the organopolysiloxane resin of component (B) and before the organopolysiloxane composition of the present invention is cured to form a cured product.

In order to prevent the curable organopolysiloxane composition of the present invention from containing the M₄Q structures, the M₄Q structures can be removed after the organopolysiloxane resin of component (B) has been synthesized and before the resin is incorporated into the organopolysiloxane composition of the present invention. The method can be a method where particulate organopolysiloxane resin is obtained as a crude raw material after the polymerization reaction in the production process of the organopolysiloxane resin, and then the particulate organopolysiloxane resin is dried in an oven or the like, or the particulate organopolysiloxane resin is removed together with the organic solvent using a twin-screw kneader. More specifically, volatile components can be removed by treating an organopolysiloxane resin containing M₄Q structures at a high temperature of about 200°C for a certain period of time, depending on the surface area of the resin, until no further mass loss is observed. For example, when 1 g of the organopolysiloxane composition is cured in an aluminum cup having a diameter of 50 mm and the resulting organopolysiloxane cured product is heated in an oven set to 200°C, the mass will decrease for about one hour, and then will be constant. Furthermore, the organic solvent and volatile components such as the M₄Q structures can be simultaneously removed from the organopolysiloxane resin that is to be component (B) by using a twin-screw kneader set at 200°C. If the temperature is set to about 200°C, a residence time in the twin-screw kneader of about 5 minutes will be sufficient. Furthermore, if the organopolysiloxane cured product to be treated is in the form of particles and is heated to this temperature while being stirred in air, the volatile low molecular weight M₄Q structures can be removed in a few minutes due to the large surface area relative to the volume.

Note that the organopolysiloxane resins are produced by polymerization reactions in the presence of an organic solvent that is highly compatible with the raw material monomers, and the resulting organopolysiloxane resin can be obtained by removing the organic solvent by drying under reduced pressure or the like. However, the M₄Q structures have a higher compatibility with the organopolysiloxane resin than the organic solvent, so removing the structures is difficult by simply using the same drying conditions that are used to remove the organic solvent. Furthermore, components (A), (C), (D), and optional component (E) that constitute the curable organosiloxane composition of the present invention do not produce these M₄Q structures during the production process, so the curable organopolysiloxane composition of the present invention or the cured product thereof can be distinguished from the conventional technology composition that contains an MQ resin containing an M₄Q structure instead of component (B) and the cured product thereof, by first heating the composition or cured product at 150°C to volatilize the organic solvent, or the like, and then heating the composition to 200°C and measuring the mass loss. Furthermore, the volatilized components can be identified by gas chromatography or the like. As described above, the M₄Q structure itself is less volatile than solvents, and therefore cannot be removed by typical raw material preparation methods, and must be removed by a specific process step aimed at removing the M₄Q structure, as described above. In addition, compounds having a molecular weight higher than that of the M₄Q structures, such as structures expressed by M₆Q₂ and M^{Vi}₄Q, do not volatilize at a temperature of about 200°C, so this step can be considered to be specialized for removing the M₄Q structures. Note that the monovalent vinyl group-containing organosiloxy units expressed by ViR³₂SiO_{1/2} is represented by MVi units.

The amount of component (B) is, for example, 10 to 80 parts by mass per 100 parts by mass of component (A). More specifically, the amount is within a range of 10 or more, 15 or more, 20 or more, 40 or more, or 50 or more, and at the same time 60 or less, 70 or less, or 80 or less. In particular, the range is 10 to 80 parts by mass, or 15 to 80 parts by mass, or 40 to 70 parts by mass. When the amount of component (B) is within the above range, the amount of M₄Q structures that can be contained in the composition of the present invention is 1.0 part by mass or less, or alternatively 0.5 part by mass or less. Needless to say, being closer to 0 parts by mass is more preferable. By analyzing the composition of the present invention using a chromatography method, the remaining amount of the M₄Q structures can be quantified from the peak of the molecular weight of the M₄Q structure.

### (C) Organohydrogenpolysiloxane crosslinking agent

Component (C) is a crosslinking agent, and is an organohydrogenpolysiloxane having at least two silicon-bonded hydrogen atoms (also referred to as SiH groups) in each molecule. The SiH groups of component (C) react with the carbon-carbon double bonds contained in component (A) and other components, in the presence of a hydrosilylation reaction catalyst to cure the organopolysiloxane composition of the present invention, which is a crosslinkable composition.

Component (C) can be an organohydrogenpolysiloxane having monovalent hydrogenorganosiloxy units expressed by HR³₂SiO_{1/2} (represented as M^{H} units. R³ is independently a monovalent organic group) or divalent hydrogenorganosiloxy units expressed by HR³SiO_{2/2} (represented as D^{H} units. R³ is independently a monovalent organic group). The structure is not particularly limited and may be linear, branched, cyclic or resinous. Specific examples of the structure of component (C) include linear organohydrogenpolysiloxanes containing M^{H} units, or a combination of linear and branched organohydrogenpolysiloxanes. However, when the organopolysiloxane cured product obtained by curing the curable organopolysiloxane composition of the present invention is used in applications requiring heat resistance, if unreacted SiH components remain in the system, further crosslinking will proceed at high temperatures, and there is a concern that the degree of needle penetration will change. Therefore, the organohydrogenpolysiloxane preferably contains MH units, which have good reactivity such that all of the SiH groups in the system react quickly, rather than D^{H} units, which have low reactivity such that all of the SiH groups do not readily react. The amount of silicon-bonded hydrogen atoms in component (C) can be measured using an infrared spectrometer.

Component (C) may consist solely of linear organohydrogenpolysiloxane (C-1), or may be a mixture of linear organohydrogenpolysiloxane (C-1) and branched organohydrogenpolysiloxane (C-2). Each component is described below.

The linear organohydrogenpolysiloxane of component (C-1) reacts with component (A) above and acts as a crosslinking agent for the composition. These linear organohydrogenpolysiloxanes have two hydrogen atoms bonded to silicon atoms (SiH groups) in each molecule, and have a viscosity in a range of 2 to 10000 mPa·s. Component (C-1) has few or no branched structures and the majority of the structure is chain-like, and in particular may have a linear structure, with SiH groups provided at both terminals of the chain. The (C-1) component can be expressed by the following average structural formula (4):

(HR³_{2S}iO_{1/2})₂(R³₂SiO_{2/2})ᵥ (4)

In formula (4), R³ represents a group similar to i) the monovalent hydrocarbon group not having aliphatic unsaturated carbon bonds in component (B) as described above, and from an industrial standpoint, examples of these groups include methyl groups or phenyl groups. Furthermore, in the formula, v represents a number of 1 or greater, and 2 + v is preferably 500 or less. An example is unbranched dimethylpolysiloxane having both molecular chain terminals blocked with dimethylhydrogensiloxy groups, where the specific structure is expressed by the following average structural formula:

(H(Me)₂SiO_{1/2})(Me₂SiO_{2/2})ᵥ₁(SiO_{1/2}(Me)₂H)

(where Me is a methyl group).
Here, v1 is a number that provides a viscosity at 25°C in a range of 2.0 to 500 mPa·s, or in a range of 2.0 to 150 mPa·s. In other words, v1 is an integer that is 1 or more and 50 or less, 100 or less, or 200 or less. Furthermore, examples include the following chain organohydrogenpolysiloxanes. Note that in the formulas, Me and Ph represent a methyl group and a phenyl group, respectively, v2 represents an integer from 1 to 100, and v3 represents an integer from 1 to 50.
HMe₂SiO(Ph₂SiO)ᵥ₂SiMe₂H
HMePhSiO(Ph₂SiO)ᵥ₂SiMePhH
HMePhSiO(Ph₂SiO)v₂(MePhSiO)v₃SiMePhH
HMePhSiO(Ph₂SiO)v₂(Me₂SiO)v₃SiMePhH

The amount of the linear organohydrogenpolysiloxane (C-1) in the organopolysiloxane composition is, for example, an amount within a range such that the number of hydrogen atoms bonded to silicon atoms per alkenyl group in component (A) exceeds 0, or is 0.1 or more, and at the same time is 1.5 or less, or 1.2 or less.

The viscosity of component (C-1) at 25°C is within a range of 2.0 to 10000 mPa·s, but may be within a range of 2.0 to 5000 mPa·s, or 2.0 to 1000 mPa·s. Component (C-1) having this viscosity contributes to improving the handling properties and flowability of the organopolysiloxane composition of the present invention, as well as the strength of the resulting cured product.

The branched organohydrogenpolysiloxane of component (C-2) is used in combination with the aforementioned component (C-1) and reacts with the aforementioned component (A) to act as a crosslinking agent for the composition. These branched organohydrogenpolysiloxanes have a branched structure, and therefore contain siloxane units expressed by R⁴SiO_{3/2} or SiO_{4/2} in a proportion that is at least 20 mol% of all siloxane units in the molecule. If the amount of these branched units is less than the lower limit, the degree of needle penetration of the resulting organopolysiloxane cured product might not be able to be effectively adjusted.

Furthermore, component (C-2) has at least three hydrogen atoms bonded to silicon atoms (SiH groups) in each molecule. The number of SiH groups in component (C-2) per molecule is 3 or more, but may be 4 or more, 5 or more, or 10 or more, and at the same time may be 500 or less, 200 or less, 100 or less, or 80 or less.

Component (C-2) may be an organohydrogenpolysiloxane expressed by the following average unit formula (5):

(R⁴₃SiO_{1/2})ⱼ(R⁴₂SiO_{2/2})ₖ(R⁴SiO_{3/2})ₘ(SiO_{4/2})ₙ(R⁵O_{1/2})ₚ (5)

(In the formula, j, k, m, n, and p are numbers that satisfy the following: 0.1 ≦ j ≦ 0.80, 0 ≦ k ≦ 0.5, 0 ≦ m ≦ 0.8, 0 ≦ n ≦ 0.6, 0 ≦ p ≦ 0.05, where m + n ≧ 0.2 and j + k + m + n = 1.)
In the formula, each R⁴ is the same or different hydrogen atom or monovalent hydrocarbon group with 1 to 10 carbon atoms without an aliphatic unsaturated carbon bond, where at least three R⁴ in one molecule are hydrogen atoms. For the monovalent hydrocarbon groups R⁴ other than a hydrogen atom, the number of carbon atoms may be any integer in a range of 1 or more and at the same time 2 or less, 3 or less, 4 or less, or 6 or less, or any integer in a range of 6 or more or 7 or more, and 8 or less, 9 or less, or 10 or less. Specific examples of the unsubstituted or substituted monovalent hydrocarbon group that does not contain an aliphatic unsaturated bond include alkyl groups; aryl groups; aralkyl groups; and groups in which some or all of the hydrogen atoms in these groups have been substituted with halogen atoms such as chlorine, bromine or fluorine. Of these, methyl, ethyl, phenyl, and benzyl groups are exemplified, and from an industrial perspective, methyl and phenyl groups are particularly preferred due to the ease of synthesis.

On the other hand, R⁵ is a hydrogen atom or an alkyl group where the number of carbon atoms is an integer in a range of 1 or more and at the same time 2 or less, 3 or less, 4 or less, or 6 or less, or the number of carbon atoms can be 6 or more, or 7 or more and at the same time 8 or less, 9 or less, or 10 or less. In other words, R⁵O_{1/2} represents a hydroxyl group or an alkoxy group. In particular, examples of R⁵ include hydrogen atoms, methyl groups, or ethyl groups, and accordingly, examples of OR⁵ include hydroxyl groups, methoxy groups, or ethoxy groups.

In the formula, j, k, m, n, and p are numbers that satisfy the following: 0.1 ≦ j ≦ 0.80, 0 ≦ k ≦ 0.5, 0 ≦ m ≦ 0.8, 0 ≦ n ≦ 0.6, 0 ≦ p ≦ 0.05, where m + n ≧ 0.2 and j + k + m + n = 1, but k = 0 is particularly preferable. If the present composition is used for heat-resistant applications, specific examples of the resinous organohydrogenpolysiloxane, which is an example of component (C-2), include M^{H}MT resin, M^{H}MTT^{H} resin, M^{H}MTQ resin, M^{H}MQ resin, M^{H}MTT^{H}Q resin, and M^{H}Q resin. Here, these resins are expressed by the siloxane units contained therein, and for example, M^{H}MTQ resin is a resin containing M units, M^{H} units, T units, and Q units in any desired ratio. Note that the M units, M^{H} units, T units, and Q units are as described above, and T^{H} units represent HSiO_{3/2}. In particular, component (C-2) is an MHQ resin expressed by:

(H(CH₃)₂SiO_{1/2})ⱼ₁(SiO_{4/2})ₙ₁

Here, j1 + n1 = 1, 0.1 ≦ j1 ≦ 0.80, and 0.20 ≦ n1 ≦ 0.90 are exemplified.

The amount of component (C-2) is, for example, an amount such that there are 0.05 to 0.8 SiH groups per alkenyl group in component (A). More specifically, an amount in a range of 0.05 or more, or 0.1 or more and at the same time 0.8 or less, or 0.75 or less is particularly exemplified. The hardness of the organopolysiloxane cured product can be effectively controlled without excessively reducing the degree of needle penetration by ensuring that the amount of component (C-2) in the organopolysiloxane composition falls within this range. If the number of SiH groups contained in component (C-2) per alkenyl group in component (A) is less than the lower limit indicated above, controlling the degree of needle penetration into the organopolysiloxane cured product by this component will be difficult.

The viscosity of component (C-2) at 25°C is within a range of 2.0 to 10000 mPa·s, preferably within a range of 2.0 to 5000 mPa·s, and more preferably within a range of 2.0 to 1000 mPa·s. The addition of component (C-2) having this viscosity improves the handling and flowability of the composition, as well as the strength of the resulting cured product.

Component (C-2) not only adjusts the degree of needle penetration of the resulting organopolysiloxane cured product, but also has the effect of improving crack resistance (particularly cracks and breakage due to internal stress caused by temperature differences inside a member). From the perspective of physical properties, including heat resistance, cold resistance, and crack resistance, of the organopolysiloxane cured product obtained by curing the organopolysiloxane composition of the present invention, the total number of hydrogen atoms bonded to silicon atoms in components (C-1) and (C-2) per 1.0 alkenyl groups contained in the entire composition is a number in a range of 0.7 or more, or 0.8 or more, and at the same time 1.2 or less, or 1.0 or less.

### (D) Hydrosilylation catalyst

Component (D) of the present invention is used as a catalyst for promoting the hydrosilylation reaction between the silicon-bonded alkenyl groups in component (A) and the silicon-bonded hydrogen atoms in component (C). Examples of the catalysts in component (D) include platinum-based catalysts, rhodium-based catalysts, palladium-based catalysts, and other non-platinum metal catalysts based on iron, ruthenium, iron/cobalt, and the like, but platinum-based catalysts are particularly exemplified for significantly promoting curing of the present composition. The platinum-based catalyst can be appropriately selected from well-known catalysts, but is represented by a platinum-alkenylsiloxane complex. The structure of the alkenylsiloxane is not limited, but 1,3-divinyl-1,1,3,3-tetramethyldisiloxane is exemplary because of the favorable stability of the complex, and the complex is preferably added in the form of an alkenylsiloxane solution. In addition, in terms of improving the handleability as well as the pot life of the composition, a platinum containing hydrosilylation reaction catalyst in microparticles dispersed and encapsulated with thermoplastic resin may be used. One type of these hydrosilylation reaction catalysts may be used alone, or two or more types may be used in combination.

In the case of a platinum-containing hydrosilylation catalyst in the form of fine particles dispersed or encapsulated in a thermoplastic resin, the platinum-based addition reaction catalyst as component (D) may be thermoplastic resin fine particles containing a platinum-containing hydrosilylation catalyst, which is a catalyst dispersed or encapsulated in a thermoplastic resin such as a silicone resin, a polycarbonate resin, or an acrylic resin. In addition, a portion or all of component (D) may be a catalyst that becomes active in the composition only upon irradiation with high-energy rays, and may be a high-energy ray-activated catalyst or a photoactivated catalyst, and may be typified by (methylcyclopentadienyl)trimethylplatinum(IV), bis(2,4-pentanedionato)platinum(II), and the like.

The amount of component (D) used may be an effective amount, and may be increased or decreased as appropriate depending on the desired curing rate. For example, in the case of a platinum-based catalyst, the amount of platinum metal is usually within a range of 0.1 to 1000 ppm, and preferably 1 to 300 ppm, on the basis of the mass of the entire composition. If the blending amount exceeds the upper limit of the above range, there is no advantage in terms of curing rate, and this is economically disadvantageous due to the price (cost) of platinum.

### (E) Reaction product of (e1) alkali metal silanolate and (e2) one or more types of cerium salts selected from cerium chloride or cerium carboxylate

Component (E) is an optional component that can be used when the organopolysiloxane composition of the present invention and/or a cured product thereof is used in applications requiring higher heat resistance. This reaction product, component (E), is described, together with a production method, in for example, Japanese Unexamined Patent Applications S49-83744 and S60-240761. The individual components which produce component (E) and the corresponding reactions are summarized below.

(e1) The alkali metal silanolate can be obtained, for example, by subjecting (e1-1) one or more type of cyclic organopolysiloxane to a ring-opening reaction with (e1-2) an alkali metal hydroxide, and then further reacting the reaction product with (e1-3) an organopolysiloxane having a viscosity at 25°C in a range of 10 to 10,000 mPa s.

The cyclic organopolysiloxane of component (e1-1) is not particularly limited, and an example is a cyclic organopolysiloxane having the following general formula (6). 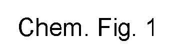 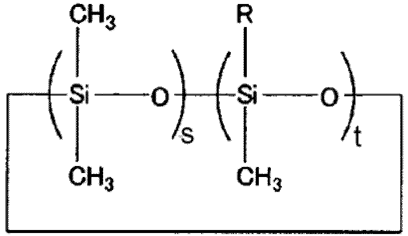 In formula (6), R represents a monovalent hydrocarbon group similar to R in general formula (1) of component (A) described above, and s and t are integers from 0 to 8, provided that 3 ≦ s + t ≦ 8. Furthermore, specific examples of the cyclic organopolysiloxane (e1-1) include hexamethylcyclotrisiloxane (D3), octamethylcyclotetrasiloxane (D4), decamethylcyclopentasiloxane (D5), and dodecamethylcyclohexasiloxane (D6), as well as those in which a portion of the methyl groups have been substituted with other hydrocarbon groups, hydrogen atoms, or reactive groups such as (meth)acryloxy groups, carboxyl groups, vinyl groups, aminopropyl groups, and the like. Furthermore, mixtures of these various organopolysiloxanes are also acceptable.

The alkali metal hydroxide of component (e1-2) is not particularly limited, and examples include sodium hydroxide, potassium hydroxide, and the like. The amount of component (e1-2) is generally 0.1 to 10 parts by mass per 100 parts by mass of component (e1-1), but is not limited to this amount, and may be adjusted depending on the reaction conditions.

The organopolysiloxane of component (e1-3) may be any conventionally known linear organopolysiloxane having a viscosity in a range of 10 to 10000 mPa·s at 25°C, and may contain some branching so long as the component remains liquid at room temperature. In addition, the silicon atom of the siloxane unit is bonded to an unsubstituted or substituted monovalent hydrocarbon group (which may be a monovalent alkenyl group) similar to the examples of R in general formula (1) of component (A). Furthermore, examples of these organopolysiloxanes include those whose molecular chain terminals are blocked with trimethylsiloxy groups and other trialkylsiloxy groups, vinyl dimethylsiloxy groups and other alkenyldialkylsiloxy groups, divinylmethylsiloxy groups and other dialkenylalkylsiloxy groups, and trivinylsiloxy groups and other trialkenylsiloxy groups, and other triorganosiloxy groups, hydroxyl groups, alkoxy groups, and the like.

The viscosity of the organopolysiloxane of component (e1-3) at 25°C is within a range of 10 mPa·s or more, or 50 mPa·s or more, and at the same time 1000 mPa·s or 10000 mPa·s. If the viscosity of component (e1-3) is 10 mPa·s or less, evaporation at high temperature tends to increase, resulting in a large mass change. The amount of component (e1-3) is not particularly limited, but generally is 0.1 to 10 parts by mass with respect to 100 parts by mass of component (e1-1).

The reaction of components (e1-1), (e1-2), and (e1-3) to obtain component (e1) is known from, for example, the aforementioned Japanese Unexamined Patent Application S60-240761, and an example of such a reaction is a reaction in which component (e1-2) is added to component (e1-1) at room temperature to open the ring of component (e1-1), and then component (e1-3) is added thereto and reacted under a nitrogen stream at, for example, 115°C for 2 hours.

The cerium salt of component (e2) is a chloride or carboxylate of cerium or a mixture of rare earth elements containing cerium as a main component. In other words, chlorides expressed by M¹Cly and carboxylates expressed by (R⁴COO)yM¹ (where R⁴ is the same or different monovalent hydrocarbon group, M¹ is cerium or a mixture of rare earth elements mainly composed of cerium, and y is 1 to 3 depending on the valence of M¹). Examples of the carboxylic acid include 2-ethylhexanoic acid, naphthenic acid, oleic acid, lauric acid, stearic acid, and the like. Note that from the perspective of ease of handling, the chloride or carboxylate of M¹ is preferably used as a solution in a lower alcohol or an organic solvent. Examples of the lower alcohol include methanol and ethanol, and examples of the organic solvent include petroleum solvents such as Stoddard solvent (mineral spirits), ligroin, petroleum ether, and the like, and aromatic solvents such as toluene, xylene, and the like.

The amount of component (e2) is, for example, an amount in which the amount of M¹ is 0.05 or more parts by mass, or 0.1 or more parts by mass, and at the same time 5 or less parts by mass, or 3 or less parts by mass, relative to 100 parts by mass of the total amount of the (e1) component. However, this is not a limitation, and the amount may be adjusted depending on the reaction conditions.

Component (E) is added in an amount within a range of 0.20 or more, or 0.3 or more, relative to 100 parts by mass of component (A), while at the same time 10.0 or less, 5.0 or less, or 0.5 or less. More specifically, the amount is a small amount of approximately 0.2 parts by mass, 0.3 parts by mass, or 0.4 parts by mass. Furthermore, the amount of component (E) added is, for example, such that the M¹ content in component (E) is within a range of 0.005 or more, or 0.01 or more, and at the same time, 0.15 mass% or 0.1 mass%, relative to the entire composition. Most of the M¹ exists as a silanolate, which is a silicon-containing compound having at least one unit in which the M¹ atom is bonded to a silicon atom via an oxygen atom, but even if M¹ exists in a different form, the M¹ is still considered as being contained in component (E). The organopolysiloxane composition can be kept advantageous for having excellent heat resistance by ensuring that the amount of component (E) falls within this range, If the amount of component (E) added is less than 0.20 parts by mass, the effect of improving heat resistance at high temperature will not be achieved. Conversely, if the amount exceeds 10 parts by mass, not only will the transparency of the organopolysiloxane cured product decrease, but the cost of the organopolysiloxane composition will increase, which is economically disadvantageous.

Component (E) can be obtained, for example, by dissolving component (e1) obtained as described above in an appropriate solvent (for example, isopropanol), adding a solution of component (e2) dropwise at room temperature to mix components (e1) and (e2), heat-treating the mixture at a temperature of 150°C or higher, filtering to recover the solid reaction product, and removing the solvent under reduced pressure and mild heating. The heating temperature of the heat treatment can be within a temperature range of 150°C or more, 200°C or more, or 250°C or more, while at the same time 310°C or less, 305°C or less, or 300°C or less. If the heating temperature is less than 150°C, a uniform composition will be difficult to obtain, but if the temperature exceeds 310°C, component (e1-3) will have a higher thermal decomposition rate, for example.

By including component (E), the high-strength organosiloxane cured product of the present invention maintains flexibility even under high-temperature conditions for long periods of time and continues to exhibit the desirable properties of low elastic modulus and low stress. In other words, the addition of component (E) to the organopolysiloxane composition of the present invention enables obtaining an organopolysiloxane cured product that has excellent heat resistance and transparency at high temperatures exceeding 200°C, and that maintains a low elastic modulus, low stress, high transparency, and crack resistance, even when used for long periods of time at high temperature.

### Other optional components

In addition to the aforementioned components (A) to (D) and optional component (E), the composition of the present invention may contain optional components such as reaction inhibitors, inorganic fillers, organopolysiloxanes that do not contain silicon-bonded hydrogen atoms and silicon-bonded alkenyl groups, adhesion promoters, heat resistance promoters, flame retardants, thixotropy promoters, pigments, dyes, and the like, provided the object of the present invention is not impaired.

The adhesion promoter is a component that improves the adhesion of the organopolysiloxane to a base material or the like, and can be appropriately selected from those generally known to a person of ordinary skill in the art. The type and quantitative range of the adhesion promoter are preferably selected from those types and amounts that do not reduce the transparency of the organopolysiloxane cured product or cause curing inhibition. The adhesion promoter can be used within any range that enables the organopolysiloxane composition of the present invention to be substantially transparent when evaluated by the method described in the Examples of the present application and to have a direct reading of 1/4 consistency as specified in JIS K2220 that is in a range of 200 or less. Examples of compounds that can be added to the organopolysiloxane composition of the present invention include titanium compounds such as tetraethyl titanate, tetrapropyl titanate, tetrabutyl titanate, tetra(2-ethylhexyl)titanate, titanium ethylacetonate, and titanium acetylacetonate; silanes expressed by the general formula (R^{a}O)_{z}SiR^{b}_{(4-z)} (where R² represents an alkyl or alkoxyalkyl group, R^{b} represents an unsubstituted or substituted monovalent hydrocarbon group, and z is 3 or 4) as disclosed in Japanese Unexamined Patent Application 2002-322364, and partial hydrolyzed condensates thereof, or combinations thereof; and in particular, silane coupling agents such as methyltrimethoxysilane, 3-glycidoxypropyltrimethoxysilane, and 3-aminopropyltrimethoxysilane can be exemplified. The amount of the adhesion promoter is not limited and can be appropriately designed, but is generally within a range of 0.001 to 5 mass%, on the basis of the total composition.

The reaction inhibitor is a component for inhibiting the hydrosilylation reaction of the organopolysiloxane composition and can be appropriately selected from those generally known to a person of ordinary skill in the art. Examples of the reaction inhibitor include acetylene-based, amine-based, carboxylate-based, and phosphite-based reaction inhibitors. The reaction inhibitor is generally added in an amount of 0.001 to 5 mass%, based on the total organopolysiloxane composition. In particular, acetylene alcohol compounds such as ethynylcyclohexanol, 3-methyl-1-butyn-3-ol, 3,5-dimethyl-1-hexyn-3-ol, 3-phenyl-1-butyn-3-ol, and the like; enyne compounds such as 3-methyl-3-penten-1-yne, 3,5-dimethyl-3-hexen-1-yne, and the like; cycloalkenylsiloxanes such as 1,3,5,7-tetramethyl-1,3,5,7-tetravinylcyclotetrasiloxane, 1,3,5,7-tetramethyl-1,3,5,7-tetrahexenylcyclotetrasiloxane, and the like; and triazole compounds such as benzotriazole and the like can be used without particular restriction, for the purpose of improving the handling and workability of the organopolysiloxane composition of the present invention.

Inorganic fillers can also be added to further increase the mechanical strength, and although there are no particular limitations on the type thereof, inorganic fillers are not generally used in cases where low viscosity and transparency are required of the organopolysiloxane composition. **If** inorganic fillers are included, an amount of 20 mass% or less, and particularly 10 mass% or less, can keep the cured product transparent. In addition, the use of nanoparticles may help maintain transparency. If transparency is not required, examples of inorganic fillers include fumed silica, crystalline silica, precipitated silica, hollow fillers, silsesquioxane, fumed titanium dioxide, magnesium oxide, zinc oxide, iron oxide, aluminum hydroxide, magnesium carbonate, calcium carbonate, zinc carbonate, laminar mica, carbon black, diatomaceous earth, glass fibers, and other inorganic fillers; fillers obtained by hydrophobically treating the surface of such inorganic fillers by organoalkoxysilane compounds, organochlorosilane compounds, organosilazane compounds, low molecular weight siloxane compounds, or other organosilicon compounds; and the like. Furthermore, silicone rubber powder, silicone resin powder and the like may also be blended.

### Preparation of organopolysiloxane composition

The organopolysiloxane composition of the present invention can be prepared by mixing the aforementioned components (A) to (D) (as well as component (E) and other optional components, when such components are blended) in a conventional manner. In doing so, components to be mixed may be divided into two or more parts and mixed as needed. For example, the components can be divided into a part including a portion of component (A) and components (C) and (D) and a part including the remainder of component (A) and component (B), and then these two parts can be mixed together. In particular, any of the parts preferably contain the aforementioned reaction inhibitor as an optional component.

The method for mixing the components of the silicone composition may be a conventional known method and is not particularly limited, but is normally uniform mixing by simple stirring. Moreover, if a solid component such as an inorganic filler is contained as any component, mixing using a mixing apparatus is more preferable. While not particularly limited thereto, exemplary such mixing apparatuses may include a single or twin shaft continuous mixer, two rolls, Ross mixer, Hobart mixer, dental mixer, planetary mixer, kneader mixer, Henschel mixer, etc.

The organopolysiloxane composition thus obtained can be suitably used as a sealant for electronic components or a laminating agent for displays. In particular, by using an organopolysiloxane composition containing component (E) as a sealant for semiconductor chips or a laminating agent for displays, the composition can effectively protect the semiconductor chips or displays after curing, without causing cracks due to heat sources or localized heating, even in harsh environments where excellent heat resistance is required.

### Curing the organopolysiloxane composition

The organopolysiloxane composition of the present invention, when cured via a hydrosilylation reaction at room temperature or at a temperature appropriate for the application, forms a gel-like organopolysiloxane cured product, or in other words, a product having a hardness within a range in which a direct reading of 1/4 consistency as specified in JIS K2220 shown below can be measured. The temperature conditions for curing are not particularly limited, but in practice the temperature is usually within a range of 60°C to 150°C. The organopolysiloxane cured product thus prepared is also an embodiment of the present invention.

### Organopolysiloxane cured product

The organopolysiloxane cured product of the present invention has excellent mechanical strength and adhesive properties and can therefore be suitably used as a laminating agent for displays, which are larger in area and have a wider temperature range for reliability. Furthermore, by using component (E) in combination, the cured product will have excellent heat resistance and transparency even at high temperatures exceeding 200°C, and can maintain a low elastic modulus, low stress, and high transparency even when used for long periods of time at high temperatures. In addition, even if the organopolysiloxane cured product is left exposed to high temperature on only one side for a long period of time, such as when a high-temperature heat source is installed on only one side (for example, the bottom surface) of the organopolysiloxane cured product, the product is less likely to develop defects such as cracks due to temperature differences and internal stresses inside the member. Furthermore, when component (E) is included and the composition is used for protecting electronic components such as semiconductor chips, SiC semiconductor chips, ICs, hybrid ICs, power devices, and the like, transparency is maintained even under high temperature and heat resistance is excellent. This can be expected to not only improve long-term durability, but also reduce degradation under low temperatures. Therefore, an electronic component with high reliability and durability can be provided under harsh conditions of use with severe temperature differences. In particular, electronic components that use a cured organopolysiloxane as a sealant or the like have high reliability and durability, even under harsh operating conditions involving large temperature differences. Note that the aforementioned semiconductor chip includes a light-emitting semiconductor element such as an LED or the like.

### 1/4 consistency

The organopolysiloxane cured product of the present invention has a direct reading value of 1/4 consistency (reading unit is 1/10 mm) as specified in JIS K2220 within a range of 10 or more, 20 or more, or 30 or more, while at the same time, 150 or less, 120 or less, or 100 or less. Cured organopolysiloxanes that exhibit a direct reading of 1/4 consistency as defined by JIS K2220 within this range have the characteristics of an organopolysiloxane cured product, such as a low modulus of elasticity and low stress. If the degree of needle penetration is less than 10, the properties of the cured organopolysiloxane, such as low elastic modulus and low stress, will be difficult to achieve, whereas if the degree of needle penetration exceeds 150, the organopolysiloxane cured product will be unable to maintain shape and will flow. Note that "direct reading of 1/4 consistency", similar to the degree of needle penetration test using a 1/4 cone stipulated in JIS K 2220, is the value obtained by dropping a 1/4 cone onto the surface of a specimen and reading the depth to which the cone penetrates, using the 1/4 consistency gauge of JIS K 2220.

### Transparency

The organopolysiloxane cured product of the present invention is preferably transparent, particularly when used in display applications. On the other hand, when used as a sealant for a power device or the like, the organopolysiloxane cured product may be colored, but maintaining substantial transparency is industrially preferable. "Substantial transparency" indicates that when a silicone gel composition that has been degassed in advance is gently poured into an aluminum cup to a thickness of 10 mm, and the absence of air bubbles is visually confirmed, and then the composition is heated at any temperature of 80°C or higher and 150°C or lower to obtain a 10 mm thick organopolysiloxane cured product, the transparency will be such that the bottom of the aluminum cup can be visually observed when viewed from above. The organopolysiloxane cured product has this level of transparency and is therefore useful as, for example, a sealant for semiconductors such as power devices and the like.

The organopolysiloxane cured product of the present invention imparts excellent durability to an electronic component provided with the organopolysiloxane cured product, so one embodiment of the present invention is a method for protecting an electronic component, the method including: 1) placing an organopolysiloxane composition and a sealing material or laminating member thereof in contact with or in the vicinity of an electronic component such as a semiconductor; and 2) curing the composition by heating, and then positioning the resulting cured product in place. Heating can be performed at a temperature in a range of about 80°C to 150°C until the composition loses fluidity, although the level depends on the heat resistance of the electronic components and the board on which the electronic components are mounted.

Furthermore, another embodiment of the present invention is an electronic component containing the aforementioned organopolysiloxane cured product, and examples of these electronic components include in-vehicle electronic components, consumer electronic components, and display members. The electronic component may be an optoelectronic component, such as a light emitting semiconductor element, such as an LED, and a general lighting fixture equipped with this type of electronic component is also included in the present invention. In particular, electronic components provided with an organopolysiloxane cured product containing component (E) may include those that are exposed to severe temperature changes, such as those found in outer space or the like. Furthermore, an embodiment of the present invention also includes a power semiconductor that is exposed to cycles of heating to high temperatures of 200°C or higher and then cooling, particularly electronic components including SiC semiconductors, and devices provided with the same. Examples of power devices including power semiconductors include motor controls, motor controls for transport aircraft, power generation systems, and space transportation systems.

### EXAMPLES

The organopolysiloxane composition and cured silicone product of the present invention will now be described in more detail with reference to examples. Note that the present invention is not limited by the descriptions of the following examples, so long as a gist of the invention is not exceeded. The viscosity in the examples is the value at 25°C.

### Production of component (E)

Component (E) was produced by the following method. Potassium silanolate compounds were prepared by a ring-opening reaction of a mixture of hexamethylcyclotrisiloxane and octamethylcyclotetrasiloxane with potassium hydroxide. 100 g of the potassium silanolate compound was dissolved in 150 g of isopropanol, which was stirred and reacted with a mixture of 2.5 g of anhydrous cerium chloride, 50 g of ethanol, and 5.0 g of methanol added dropwise. The reaction mixture was filtered, and the filtrate was heated to 40 to 50°C under reduced pressure to remove ethanol and methanol. This was then filtered again to prepare a pale yellow liquid reaction product. The cerium content in this reaction product was 1.4 mass%.

### Evaluation of organopolysiloxane composition and organopolysiloxane cured product

The transparency, 1/4 consistency, heat resistance, and crack resistance of the organopolysiloxane cured product of the present invention were measured as follows.

### Preparation of organopolysiloxane cured product

The organopolysiloxane composition was gently poured into a 50 mL glass beaker to a height of 3 cm from the bottom of the beaker, and then heated at 80°C for 1 hour to produce the organopolysiloxane cured product.

### Measurement of 1/4 consistency

In accordance with the 1/4 cone degree of needle penetration test specified in JIS K2220, a 1/4 cone was dropped onto the surface of the target organopolysiloxane cured product using a 1/4 cone degree of needle penetration meter according to JIS K2220, the depth to which the cone penetrated was read (reading units were 1/10 mm), and this value was recorded as the "direct reading value".

### Heat resistance of organopolysiloxane cured product

The organopolysiloxane cured product obtained by the above method was placed in an oven at 225°C and then removed after 1000 hours and allowed to stand at room temperature and naturally cooled to 25°C. Thereafter, the 1/4 consistency of the organopolysiloxane cured product was measured and the direct reading (reading unit: 1/10 mm) was recorded as the 1/4 consistency.

### Crack resistance of organopolysiloxane cured product

The organopolysiloxane cured product obtained by the above method was placed on a hot plate heated to 225°C, and the external appearance of the organopolysiloxane was then observed through a beaker for 1000 hours. If cracking was visually observed within 1000 hours, the time was recorded.

### Mechanical strength and adhesive strength of organopolysiloxane cured product

The adhesive strength and mechanical strength were measured in accordance with the method specified in JIS K6850/1999 using two aluminum plates measuring 25 mm × 75 mm × 1 mm. Note that when the test was terminated with cohesive failure of the organopolysiloxane, the adhesive strength directly indicates the mechanical strength of the organopolysiloxane.

### Examples 1 to 8 and Comparative Examples 1 to 13

The components shown in Tables 1, 2, 3, and 4 below were mixed uniformly in the compositions (parts by mass) shown in Tables 5 and 6 to prepare 21 types of organopolysiloxane compositions. These organopolysiloxane compositions were cured by the methods described above for each of the evaluation methods, and the resulting organopolysiloxane cured products were evaluated for 1/4 consistency, heat resistance, and crack resistance. The results are summarized in Tables 5 and 6 below. Note that in the table, SiH/Vi indicates the number of moles of silicon-bonded hydrogen atoms in the combined components (C-1) and (C-2) per mole of vinyl groups contained in the combined components (A-1), (A-2), and (D). Furthermore, the platinum metal content of component (D) is shown in ppm in the composition.

**Table 1**

| Component | Substance name and structure | Viscosity (Mpa·s) | Vi group content (mass%) |
|---|---|---|---|
| A-1-1 | Branched polyorganosiloxane having at least two vinyl groups in one molecule | 680 | 0.21 |
| | 94.5 mol% of (CH₃)₂SiO_{2/2} units, 2.3 mol% of CH₃SiO_{3/2} units, 2.3 mol% of (CH₃)₃SiO_{1/2} units, and | | |
| | 0.9 mol% of (CH₃)₂(CH₂=CH)SiO_{1/2} units (weight average molecular weight * approximately 40000) | | |
| A-2-1 | Linear dimethylpolysiloxane capped at both molecular terminals with dimethylvinylsiloxy groups | 2200 | 0.22 |
| | ((CH₃)₂(CH₂=CH)SiO_{1/2})₂((CH₃)₂SiO_{2/2})₃₀₀ | | |
| A-2-2 | Linear dimethylpolysiloxane capped at both molecular terminals with dimethylvinylsiloxy groups | 700 | 0.44 |
| | ((CH₃)₂(CH₂=CH)SiO_{1/2})₂((CH₃)₂SiO_{2/2})₁₄₀ | | |
| A-2-3 | Dimethylpolysiloxane capped at both molecular terminals with dimethylvinylsiloxy groups, | 2000 | 0.18 |
| | ((CH₃)₂(CH₂=CH)SiO_{1/2})₂((CH₃)₂SiO_{2/2})₂₅₀ | | |
| | ((CH₃)(C₆H₆)SiO_{2/2})₃₀ | | |

| | | | |
|---|---|---|---|
| * The weight average molecular weight (Mw) is the weight average molecular weight calculated using a polystyrene standard and measured by gel permeation chromatography (GPC). | | | |

**Table 2**

| Component | Structure (average unit formula) | Condition at 25°C | Volatile content ★ (mass%) | Vi group content (mass%) |
|---|---|---|---|---|
| B-1 | (Me₃SiO_{1/2})_{0.44}(SiO_{4/2})_{0.56}(HO_{1/2})_{0.02} | White solid | 0.8 | 0 |
| B-2 | (Me₃SiO_{1/2})_{0.49}(SiO_{4/2})_{0.5}(HO_{1/2})_{0.02} | White solid | 0.7 | 0 |
| B-3 | (Me₂ViSiO_{1/2})_{0.05}(Me₃SiO_{1/2})_{0.39} | White solid | 0.7 | 1.9 |
| | (SiO_{4/2})_{0.56}(HO_{1/2})_{0.02} | | | |
| B' | (Me₃SiO_{1/2})_{0.44}(SiO_{4/2})_{0.56}(HO_{1/2})_{0.02} | White solid | 4.7 | 0 |
| B" | (Me₃SiO_{1/2})_{0.44}(SiO_{4/2})_{0.56}(HO_{1/2})_{0.02} | White solid | 3.8 | 0 |

| | | | | |
|---|---|---|---|---|
| * The volatile content equals the mass loss expressed as a percentage when approximately 1 g of this organopolysiloxane resin is weighed into an aluminum cup with a diameter of 50 mm and left at 200°C for 1 hour. This value coincides with the amount of M₄Q structures remaining in the B component as described above. | | | | |

**Table 3**

| Component | Substance name and structure | Viscosity (Mpa·s) | SiH* content (mass%) |
|---|---|---|---|
| C-1-1 | Linear polyorganosiloxane | 20 | 0.13 |
| | HMe₂SiO(Me₂SiO)₁₇SiMe₂H | | |
| C-1-2 | Linear polyorganosiloxane | 25 | 0.14 |
| | HMe₂SiO(MeHSiO)₁(Me2SiO)₂₅SiMe₂H | | |
| C-2-1 | Branched polyorganosiloxane | 25 | 0.96 |
| | ((CH₃)HSiO_{1/2})0.67(SiO_{4/2})0.33 | | |

| | | | |
|---|---|---|---|
| * SiH amount = amount of silicon-bonded hydrogen atoms | | | |

**Table 4**

| Component | Substance |
|---|---|
| D | A complex of platinum and 1,3-divinyl-1,1,3,3-tetramethyldisiloxane having a platinum content of 0.5% by weight (Vi group amount = 2.48 wt.%). |
| E | Reaction products of alkali metal silanolates prepared by the above method and cerium chloride |
| F | Ethynylcyclohexanol (reaction inhibitor) |
| G | Ethyl silicate 40 (manufactured by Colcoat Co., Ltd.) (adhesion imparting component) |

### Summary

As shown in Table 5, Examples 1-5 of the present application exhibited the performance of the basic organopolysiloxane composition of the present invention. The cured products of these compositions contained component (B), which is characteristic of the present invention, and were observed to have higher adhesive strength and mechanical strength than Comparative Examples 1 and 2, which did not contain a sufficient amount of component (B). It was therefore demonstrated that a composition containing component (B) can provide a stronger organopolysiloxane composition. Furthermore, looking at Comparative Examples 3 and 4, the contribution of component (C) to performance within the scope of the present invention can be confirmed. Comparative Examples 5 and 6 have the same composition as Example 4 except that component (B) contains a volatile component. However, the strength was relatively poor, the 1/4 consistency was high, and there was variation. Therefore, the basic organopolysiloxane cured product of the present invention exhibits stable high strength and can be suitably used in applications where strength is required. Table 6 shows Examples 6 to 8 and a Comparative Example in which the optional component (E) was added. The heat resistance of the organopolysiloxane cured products obtained from these compositions and the crack resistance when heated from one direction at 225°C for a long period of time were generally favorable, and the 1/4 consistency after 1000 hours at high temperature did not change significantly. However, when component (B) was not included, as in Comparative Examples 7 to 11, the strength was significantly inferior. Furthermore, Comparative Examples 12 and 13 have the same compositions as those of Examples 7 and 8, respectively, except that component (B) contains a volatile component. However, since component (B) does not have a mass loss rate of 2.0 mass% or less when exposed to 200°C for 1 hour, which is a feature of the present invention, the crack resistance was significantly inferior.

### Table 5. Performance of the base composition

**Table 5**

| | EXAMPLE 1 | EXAMPLE 2 | EXAMPLE 3 | EXAMPLE 4 | EXAMPLE 5 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 |
|---|---|---|---|---|---|---|---|---|---|---|---|
| A-1-1 | | | | | | | 53.2 | | | | |
| A-2-1 | 46 | 18.3 | 28 | 33 | | 54.7 | 40 | 46 | 33 | 33 | 33 |
| A-2-2 | 37 | 55.2 | 37.5 | 28.4 | 55.7 | 37 | | 37 | 28.4 | 28.4 | 28.4 |
| A-2-3 | | | | | | | | | | | |
| B-1 | 9.2 | 18.3 | 28 | 33 | | | | 9 | 33.1 | | |
| B-2 | | | | | 37.3 | | | | | | |
| B-3 | | | | | | | | | | | |
| B' | | | | | | | | | | 33 | |
| B" | | | | | | | | | | | |
| C-1-1 | 6 | 6.3 | 4.1 | 2.9 | 4.2 | 6.5 | 6.05 | 7.6 | 1.4 | 2.9 | 2.9 |
| C-1-2 | 1.7 | 1.8 | 2.3 | 2.6 | 2,7 | 1.7 | | 0.3 | 4 | 2.6 | 2.6 |
| C-2-1 | | | | | | | | | | | |
| D PT METAL CONTENT [PPM] | 10 | 10 | 10 | 10 | 10 | 10 | 10 | 10 | 10 | 10 | 10 |
| E | | | | | | | | | | | |
| F | 0.1 | 0.1 | 0.1 | 0.1 | 0.1 | 0.1 | 0.1 | 0.1 | 0.1 | 0.1 | 0.1 |
| G | | | | | | | | | | | |
| SiH/Vi | 1.00 | 0.98 | 0.99 | 0.98 | 0.99 | 0.99 | 1.01 | 1.00 | 1.00 | 0.98 | 0.98 |
| AMOUNT OF M₄Q STRUCTURE IN THE COMPOSITION (WT%) ^{(*1)} | 0.074 | 0.146 | 0.224 | 0.264 | 0.261 | - | - | 0.072 | 0.265 | 1.551 | 1.254 |
| 1/4 CONSISTENCY (INITIAL) | 60 | 53 | 51 | 40 | 57 | 58 | 75 | 230 | <10 | 77 | 61 |
| ADHESIVE STRENGTH ^{(*2)} (MPA) | 0.45 | 0.67 | 0.73 | 1.05 | 0.72 | 0.23 | 0.10 | | | 0.83 | 0.86 |

| | | | | | | | | | | | |
|---|---|---|---|---|---|---|---|---|---|---|---|
| (*1) Calculated from the components contained in component B that volatilize at 200°C, or in other words, the amount of M₄Q structures. (*2) The failure modes in all adhesion tests were cohesive failure, so adhesive strength = mechanical strength of the organopolysiloxane cured product. | | | | | | | | | | | |

### Table 6. Effects of component (B) in heat-resistant organopolysiloxane compositions containing component (E)

**Table 6**

| | EXAMPLE 6 | EXAMPLE 7 | EXAMPLE 8 | COMPARATIVE EXAMPLE 7 | COMPARATIVE EXAMPLE 8 | COMPARATIVE EXAMPLE 9 | COMPARATIVE EXAMPLE 10 | COMPARATIVE EXAMPLE 11 | COMPARATIVE EXAMPLE 12 | COMPARATIVE EXAMPLE 13 |
|---|---|---|---|---|---|---|---|---|---|---|
| A-1-1 | | | | 95.4 | 86.45 | | | 53.2 | | |
| A-2-1 | 27.9 | 27.5 | 33 | | 5 | 93.65 | | 40 | 27.5 | 33 |
| A-2-2 | 37.3 | 37.8 | 28.9 | | | | | | 37.8 | 28.9 |
| A-2-3 | | | | | | | 94.8 | | | |
| B-1 | 27.7 | | | | | | | | | |
| B-2 | | | | | | | | | | |
| B-3 | | | | | 3 | | | | | |
| B' | | | | | | | | | 28 | 32.85 |
| B" | | | | | | | | | | |
| C-1-1 | 4.1 | 5.8 | 4.3 | 3.6 | 4.4 | 5.52 | 4.35 | 6.05 | 5.8 | 4.3 |
| C-1-2 | 2.3 | | | | | | | | | |
| C-2-1 | | 0.12 | 0.2 | 0.3 | 0.4 | 0.1 | 0.1 | | 0.12 | 0.2 |
| D PT METAL CONTENT [PPM] | 10 | 10 | 10 | 10 | 10 | 10 | 10 | 10 | 10 | 10 |
| E | 0.5 | 0.5 | 0.5 | 0.5 | 0.5 | 0.5 | 0.5 | 0.5 | 0.5 | 0.5 |
| F | 0.1 | 0.1 | 0.1 | 0.1 | 0.1 | 0.1 | 0.1 | 0.1 | 0.1 | 0.1 |
| G | 0.15 | 0.15 | 0.15 | 0.15 | 0.15 | 0.15 | 0.15 | 0.15 | 0.15 | 0.15 |
| SiH/Vi | 0.99 | 0.99 | 0.98 | 0.99 | 1.00 | 1.00 | 1.01 | 1.01 | 0.99 | 0.98 |
| AMOUNT OF M₄Q STRUCTURE IN THE COMPOSITION (WT%) ^{(*1)} | 0.222 | 0.224 | 0.263 | - | 0.021 | - | - | - | 1.316 | 1.544 |
| 1/4 CONSISTENCY (INITIAL) | 24 | 53 | 21 | 51 | 23 | 31 | 78 | 75 | 98 | 67 |
| 1/4 CONSISTENCY (AFTER 225°C/1000 HOURS) | 11 | 38 | 10 | 43 | 18 | 19 | 58 | 55 | 35 | <10 |
| ADHESIVE STRENGTH ^{(*2)} (MPA) | 1.4 | 0.85 | 1.6 | 0.25 | 0.38 | 0.45 | 0.31 | 0.1 | 0.62 | 1.2 |
| CRACK RESISTANCE | 1000 HRS | 1000 HRS | 1000 HRS | 810 HRS | 1000 HRS | 1000 HRS | 780 HRS | 250 HRS | 380 HRS | 250 HRS |

| | | | | | | | | | | |
|---|---|---|---|---|---|---|---|---|---|---|
| (*1) Calculated from the components contained in component B that volatilize at 200°C, or in other words, the amount of M₄Q structures. (*2) The failure modes in all adhesion tests were cohesive failure, so adhesive strength = mechanical strength of the organopolysiloxane cured product. | | | | | | | | | | |

### INDUSTRIAL APPLICABILITY

The organopolysiloxane cured product obtained from the organopolysiloxane composition of the present invention has strength and transparency, and therefore examples of applications include sealants for various semiconductor elements, protective materials, sealants for optical elements, laminating materials for displays, optical components or optoelectronic components used in general lighting fixtures and the like, lenses (including secondary optical lens materials provided on the outside of LED packages), light diffusing components, white reflector components, wavelength conversion members, optical waveguides, light guiding materials, and the like. When used as an optical or optoelectronic member, various functional fillers (fluorescent, light diffusing, translucent, coloring, reinforcing fillers, and the like) may be added to the organopolysiloxane composition of the present invention. The organopolysiloxane composition of the present invention can be used in the same manner as conventional organopolysiloxane compositions having similar optical properties, and due to the high strength, provides better protection for devices and components containing the composition as compared to conventional compositions, thereby increasing their reliability.

Furthermore, the organopolysiloxane cured product obtained from the organopolysiloxane composition of the present invention containing component (E) not only has heat resistance of 200°C or more, which is required for SiC semiconductor chips, but is also less likely to crack even when high temperatures are applied from only one direction, allowing for a high degree of freedom in circuit design, including thermal management, and is also suitably used as a sealant or protective material for power devices in which heat is generated only from the lower part of the device, thereby improving the durability and reliability of these power devices. Examples of power devices requiring this heat resistance and crack resistance include general-purpose inverter controllers, servo motor controllers, motor controllers for machine tools, elevators, and the like, motor controllers for electric vehicles, hybrid cars, and railway transport vehicles, generator systems for solar, wind, fuel cell power generation, and the like, and space transportation systems used in outer space, and the like.

## Claims

1. An organopolysiloxane composition, comprising:
(A) 100 parts by mass of an organopolysiloxane having, on average, at least two alkenyl groups bonded to silicon atoms per molecule and having a viscosity at 25°C in a range of 10 to 10,000 mPa·s;
(B) 10 to 80 parts by mass of an organopolysiloxane resin expressed by the following formula:
(R¹₃SiO_{1/2})ₐ(SiO_{4/2})b(R²O_{1/2})_{c}
(where each R¹ is independently a monovalent hydrocarbon group having 1 to 10 carbon atoms and not containing an aliphatic carbon-carbon double bond; R² is a hydrogen atom or an alkyl group having 1 to 10 carbon atoms; and a, b, and c are numbers satisfying 0.35≦a≦0.55, b=1-a, and 0≦c≦0.05),
the mass loss rate when exposed to 200°C for 1 hour being 2.0 mass% or less relative to the mass of component (B);
(C) an organohydrogenpolysiloxane having at least two hydrogen atoms bonded to silicon atoms in each molecule and having a viscosity at 25°C in a range of 2 to 10000 mPa·s in an amount such that the number of hydrogen atoms bonded to silicon atoms per alkenyl group bonded to silicon atoms in the entire composition is 0.5 to 2.0;
(D) a hydrosilylation catalyst in an amount sufficient to react and cure components (A) to (C); and optionally
(E) 0 to 10 parts by mass of a reaction product of (e1) an alkali metal silanolate and (e2) at least one salt selected from chlorides expressed by M¹Cl_{y} and carboxylates expressed by (R⁴COO)_{y}M¹ (where R⁴ represents the same or different monovalent hydrocarbon groups, M¹ is cerium or a mixture of rare earth elements mainly composed of cerium, and y is 1 to 3, depending on the valence of M¹).

2. The organopolysiloxane composition according to claim 1, wherein the amount of M₄Q structures is 1.0 parts by mass or less.

3. The organopolysiloxane composition according to claim 1 or claim 2, wherein component (A) is either one or a mixture of:
(A-1) branched organopolysiloxane expressed by the following general formula (1), with at least two alkenyl groups bonded to silicon atoms in each molecule, having a viscosity at 25°C in a range of 10 to 10000 mPa·s
(R₃SiO_{1/2})_{d}(R₂SiO_{2/2})ₑ(RSiO_{3/2})_{f} (1)
(where each R independently represents a monovalent hydrocarbon group, at least two of which are alkenyl groups, and d, e, and f are numbers whose percentages relative to the total of d, e, and f satisfy 0.1≦d≦10.0, 80.0≦e≦99.8, and 0.1≦f≦10.0); and
(A-2) a linear organopolysiloxane having at least two alkenyl groups bonded to silicon atoms in each molecule and having a viscosity at 25°C in a range of 10 to 10,000 mPa·s.

4. The organopolysiloxane composition according to claim 3, wherein 0.25 to 4.00 mol% of all monovalent hydrocarbon groups bonded to silicon atoms in component (A-1) are alkenyl groups.

5. The organopolysiloxane composition according to any one of claims 1 to 4, wherein
component (C) includes:
(C-1) a linear organohydrogenpolysiloxane having a viscosity at 25°C in a range of 2 to 1,000 mPa·s and having two silicon-bonded hydrogen atoms in each molecule, in an amount such that the amount of silicon-bonded hydrogen atoms per silicon-bonded alkenyl group in the entire composition is greater than 0 and 2.0 or less; and optionally
(C-2) a branched organohydrogenpolysiloxane having a viscosity at 25°C in a range of 2 to 1000 mPa·s, having three or more hydrogen atoms bonded to silicon atoms in each molecule, where at least 20 mol% of all siloxane units are siloxane units expressed by R⁴SiO_{3/2} (where R⁴ is a monovalent hydrocarbon group) or SiO_{4/2}, in an amount such that 0.1 to 0.8 hydrogen atoms bonded to silicon atoms are present per alkenyl group bonded to silicon atoms in the entire composition.

6. The organopolysiloxane composition according to claim 1 or 2, wherein component (E) contains 0.5 to 5.0 mass% of M¹ atoms.

7. An electronic component sealant, comprising the organopolysiloxane composition according to any one of claims 1 to 6.

8. The electronic component sealant according to claim 7, which is substantially transparent.

9. An organopolysiloxane cured product, obtained by curing the organopolysiloxane composition according to any one of claims 1 to 6, having a direct reading of 1/4 consistency as specified in JIS K2220 within a range of 10 to 150.

10. The organopolysiloxane cured product according to claim 9, which is substantially transparent.

11. An electronic component, comprising: the electronic component sealant according to claim 7 or claim 8 or the organopolysiloxane cured product according to claim 9 or claim 10.

12. The electronic component according to claim 11, mounted on a power device.

13. The electronic component according to claim 11, wherein the electronic component is an optoelectronic component.

14. The electronic component according to claim 13, mounted on a general lighting device, a display member, an optical member, or an optoelectronic member.

15. A method for protecting a semiconductor chip, comprising:
using the organopolysiloxane composition according to any one of claims 1 to 6, the electronic component sealant according to claim 7, or the organopolysiloxane cured product according to claim 9.
